# FASCICULE DE BREVET EUROPEEN

(11) **EP 1 449 017 B1**
(45) Date de publication et mention de la délivrance du brevet: **29.08.2007**
(21) Numéro de dépôt: 02801070.0
(22) Date de dépôt: 20.11.2002
(51) Int. Cl.: G02B 5/04

(54) **PLAQUE TRANSPARENTE TEXTUREE A FORTE TRANSMISSION DE LUMIERE**
TEXTURIERTE TRANSPARENTE PLATTE MIT GROSSER LICHTDURCHLÄSSIGKEIT
TEXTURED TRANSPARENT PLATE WITH HIGH LIGHT TRANSMISSION

(30) Priorité: 28.11.2001 FR 0115352
(43) Date de publication de la demande: 25.08.2004
(73) Titulaire: SAINT-GOBAIN GLASS FRANCE, 92400 Courbevoie (FR)
(72) Inventeur: BLIESKE, Ulf, 41236 Mönchengladbach (DE); DOEGE, Thomas, 52249 Eschweiler (DE); NEANDER, Marcus, 52249 Eschweiler (DE); PRAT, Aurélia, LONDON E1W 2JB (GB); GAYOUT, Patrick, F-93250 Villemonble (FR)
(74) Mandataire: Colombier, Christian
(86) Numéro de dépôt international: PCT/FR2002/003964
(87) Numéro de publication internationale: WO 2003/046617

(56) Documents cités:
- EP-A- 1 127 984
- WO-A-99/56158
- GB-A- 2 066 565
- US-B1- 6 275 338
- PATENT ABSTRACTS OF JAPAN vol. 1995, no. 08, 29 septembre 1995 (1995-09-29) & JP 07 114025 A (SHARP CORP), 2 mai 1995 (1995-05-02)
- PATENT ABSTRACTS OF JAPAN vol. 1997, no. 04, 30 avril 1997 (1997-04-30) & JP 08 327807 A (PIONEER ELECTRON CORP;PIONEER SEIMITSU KK), 13 décembre 1996 (1996-12-13)
- NIKOGOSYAN: "Properties of optical and laser related materials" 1997 , WILEY , CHICHESTER XP001040831 page 174-175

## Description

L'invention concerne le domaine des plaques transparentes antireflets et capables de piéger la lumière. La plaque transparente selon l'invention comprend, sur au moins une de ses surfaces une texturation, c'est-à-dire une pluralité de motifs géométriques en relief, concaves ou convexes par rapport au plan général de la face texturée de la plaque. Les deux côtés de la plaque peuvent présenter de tels motifs. Grâce à sa texturation, la plaque présente une propriété de transmission de la lumière améliorée. Dans le cadre de la présente demande, le terme antireflet est utilisé pour exprimer une diminution de la réflexion (et non pas nécessairement une absence totale de réflexion). La plaque selon l'invention procure une bonne transmission de la lumière quelle que soit l'orientation de la lumière incidente.

La plaque selon l'invention trouve une utilité lorsqu'elle est placée à proximité (généralement à moins de 50 cm) d'un élément capable de collecter de la lumière. Notamment, lorsque la plaque selon l'invention est placée au-dessus de la surface (par exemple en silicium) d'une cellule photoélectrique, la plaque selon l'invention procure un gain de réception de la lumière par ladite cellule. Bien qu'il soit imaginable de texturer la surface en silicium de la cellule photoélectrique de façon à augmenter son efficacité, on ne sait pas toujours comment texturer une telle surface, notamment lorsque ladite surface est polycristalline. L'invention, en proposant de texturer au moins une surface d'une plaque transparente placée au-dessus de la surface de la cellule, procure donc la seule solution pour augmenter le flux lumineux transmis vers la cellule, lorsque la surface de celle-ci est polycristalline et notamment en silicium polycristallin.

Le US5994641 enseigne des modules comprenant des cellules solaires alignées, lesdits modules pouvant comprendre un film thermoplastique ayant une pluralité de cavités parallèles en V. Ces structures sont linéaires et placées entre les cellules alignées d'un même module. Le film comprend une pluralité de relief en V défini par une paire de surfaces convergentes. Le film est revêtu du coté du relief par un film métallique réfléchissant la lumière.

Le US4918030 enseigne la formation par attaque chimique de motifs pyramidaux en surface de silicium monocristallin destiné à la fabrication de cellules photovoltaïques. Ces motifs en pyramides ont des côtés d'environ 20 µm. Ces surfaces sont plus efficaces pour piéger la lumière.

Le GB2066565 enseigne la formation de motifs pyramidaux réguliers concaves (pyramides inversées) en surface de silicium destiné à la fabrication de cellule collectant l'énergie solaire. Le procédé de préparation inclut la formation d'une couche résistante (SiO₂) au produit d'attaque du Si, ladite couche présentant des trous, puis une attaque du Si, intervenant nécessairement aux trous. La surface ainsi préparée présente une meilleure absorption de la lumière (Trapping) et une moins forte réflexion de la lumière. Il s'agit d'un procédé complexe dû au fait que le silicium est polycristallin, ce qui rend difficile la texturation par attaque chimique. En effet, l'attaque chimique est très dépendante de l'orientation cristalline.

On connaît par le document US675338 l'usage d'une plaque comprenant une face texturée et une couche de diffusion pour réguler la lumière la traversant. La face texturée permet de réguler la lumière en direction de la couche diffusion mais ne possède pas de propriété antireflet.

On connaît en outre par le document US5396350 le recours à une plaque transparente comportant sur l'une de ses faces une pluralité de motifs en relief par rapport au plan général de ladite plaque, ces motifs étant séparés les uns des autres par un espace transversal et longitudinal, et étant capables, en raison de leurs géométries, de collecter ou d'émettre de la lumière.

Le FR2551267 concerne un transducteur photo-électrique à film mince capable d'allonger le trajet optique pour améliorer sa propriété d'absorption optique. Sa surface est plane du côté de la réception de la lumière et rugueuse sur le côté opposé. Une couche de transduction photo-électrique (SnO₂) est appliquée sur la surface rugueuse du substrat (en verre). Le relief rugueux peut être du type « pyramide », « en toit à deux pentes », du type « en cône ». L'avantage de cette configuration est que la surface externe étant plane, elle retient moins la poussière. L'efficacité de la conversion photo-électrique, en allongeant le trajet optique de la lumière incidente, est amélioré. La rugosité est réalisée par meulage de la surface d'un verre par un abrasif (p 12, 15) suivi d'une attaque chimique. Les motifs ont pour dimension environ 0,1 µm - 1 µm.

L'article REDUCTION OF REFLECTION LOSSES OF PV MODULES BY STRUCTURED SURFACES, Solar Energy, Vol. 53, No.2, pp. 171-176, 1994 enseigne un revêtement en verre anti-réflexion pour les cellules photo-électriques, II enseigne que le plus simple est une structure « random » mais qu'une telle structure est susceptible de retenir la poussière. Une couche transparente ayant une structure en V avec des lignes parallèles s'étendant tout le long de la cellule est préconisée.

La demande de brevet français n°0008842 enseigne la formation par CVD de couches présentant des excroissances comme des cônes ou des colonnes perpendiculaires au plan principal du substrat en verre, et ce afin de constituer un état de surface hydrophobe/oléophobe.

Le FR2792628 enseigne un substrat hydrophobe/oléophobe ou hydrophile/oléophile présentant un relief comprenant un niveau haut et un niveau bas de surface sur une hauteur de 0,01 à 10 µm.

Le WO98/23549 enseigne un substrat à propriétés hydrophiles ou hydrophobes comportant en tant qu' irrégularités de surface des bosses et creux aux dimensions submicroniques. Cette surface peut être munie d'un agent photocatalytique tel que l'oxyde de titane, au moins partiellement cristallisé (de type anatase).

Le EP0493202 enseigne la réalisation de vitrages diffusants par laminage à chaud imprimant un relief de cratères pyramidaux à base hexagonale ou carré. La lumière transmise est répartie régulièrement de sorte que l'on ne distingue à l'oeil nu aucune structure lorsque le vitrage est éclairé à une distance inférieure à six mètres. Les motifs s'inscrivent dans des cercles de diamètre compris entre 0,5 et 1,7 mm.

La plaque transparente selon l'invention comprend les caractéristiques de la revendication 1 sur au moins une de ses surfaces une pluralité de motifs géométriques en relief, concaves et/ou convexes par rapport au plan général de la face texturée de la plaque. Les deux côtés de la plaque peuvent présenter de tels motifs.

La plaque transparente texturée selon l'invention permet d'augmenter la transmission grâce à deux principes. D'une part, la réduction de la réflexion sur sa face texturée est obtenue par des réflexions multiples sur la surface qui offrent à la lumière un nombre de possibilités plus importantes de rentrer dans la plaque. De plus, la lumière a des angles d'incidence plus faibles sur les faces des motifs pour des rayons lumineux qui auraient eu des angles d'incidence élevés sur une surface plane. Par exemple avec une pyramide de demi-angle au sommet 45°, les rayons qui seraient arrivés avec un angle d'incidence variant entre 0 et 90° sur une surface plane rencontrent la surface de la texture avec un angle d'incidence entre -45° et +45°. Comme le domaine des angles élevés (plus on s'approche de 90°) favorise la réflexion, le remplacement du domaine 0 à 90° par le domaine -45 à +45° s'accompagne d'une diminution sensible de la réflexion. D'autre part, la lumière réfléchie après son entrée dans la plaque est piégée par réflexion sur les faces des motifs et une plus grande partie de la lumière est transmise à travers la plaque. Les pertes en réflexion sont ainsi beaucoup plus faibles.

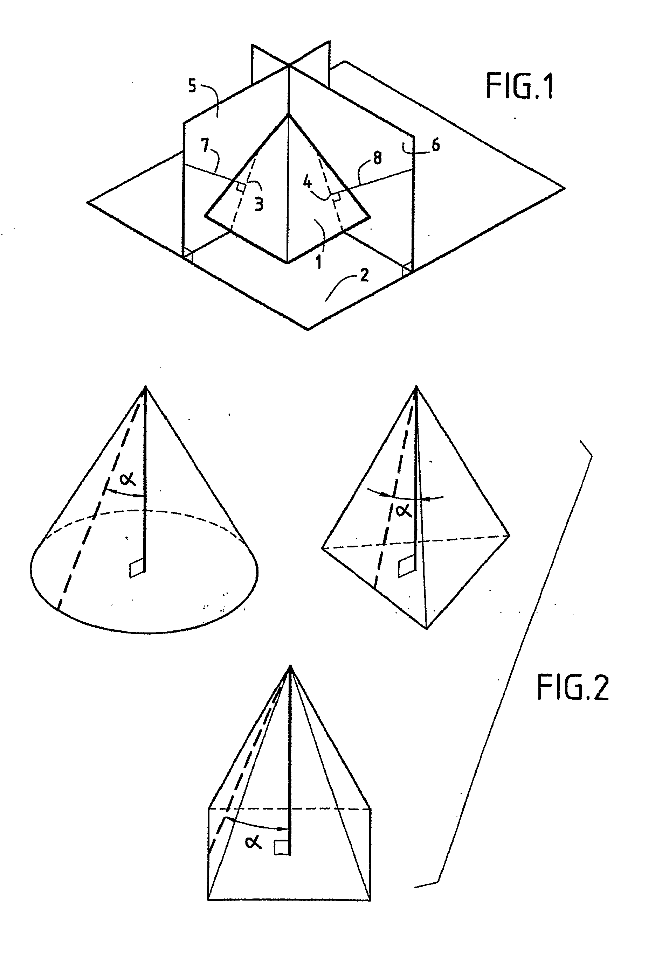

La surface desdits motifs comprend au moins deux points tels que les deux plans perpendiculaires au plan général de la face texturée de la plaque, et tels que chacun d'eux contient l'une des deux droites perpendiculaires à ladite surface et passant par l'un desdits deux points, ne sont pas parallèles, c'est-à-dire sont sécants. Ces deux plans peuvent par exemple être perpendiculaires entre eux. De préférence, ces deux points peuvent se situer tous deux sur une zone plane de la surface du motif. La figure 1 illustre ce que l'on entend par ces points et plans. Cette figure 1 représente un motif 1 ayant la forme d'une pyramide régulière à base carrée venant en excroissance par rapport au plan général 2 de la face texturée de la plaque. Dans le cadre de la présente demande, on appelle « pyramide régulière », une pyramide dont toutes les faces sont planes et identiques. On voit que la pyramide comprend bien au moins deux points 3 et 4 tels que les plans 5 et 6 perpendiculaires au plan général 2 de la face texturée de la plaque et qui contiennent respectivement les droites 7 et 8 normales à la surface des motifs aux points 3 et 4, ne sont pas parallèles. Dans le cas d'une telle pyramide régulière à base carrée, ces deux plans 5 et 6 sont même perpendiculaires entre eux.

Ainsi, l'invention concerne également un ensemble selon la revendication 15, ladite plaque étant texturée sur au moins une de ses faces par une pluralité de motifs géométriques en relief par rapport au plan général de ladite face, la face texturée étant placée du côté de la réception de la lumière (c'est-à-dire du côté de la source de lumière), la surface desdits motifs comprenant chacun au moins deux points tels qu'il existe deux plans sécants entre eux contenant chacun l'un desdits deux points et réunissant les deux conditions suivantes :
a) ces plans sont tous deux perpendiculaires au plan général de la face texturée de la plaque, et
b) ces plans contiennent chacun l'une des deux droites perpendiculaires à ladite surface et passant par l'un desdits deux points.

Ces conditions sont forcément remplies pour un motif en forme de cône ou de pyramide. Ces conditions ne sont pas remplies dans le cas des motifs linéaires en V de l'art antérieur.

De préférence, les points par lesquels passent les plans sécants se trouvent sur des surfaces planes, par exemple des faces planes d'une pyramide. Un cône ne présente pas de surface plane. Généralement, les motifs se terminent en pointe, comme c'est le cas pour un cône ou une pyramide, c'est-à-dire que le point du motif le plus éloigné du plan général de la plaque est le sommet d'une pointe.

La surface desdits motifs peut comprendre au moins trois points tels que les différents plans perpendiculaires au plan général de la face texturée de la plaque, et tels que chacun d'eux contient l'une des trois droites perpendiculaires à ladite surface et passant par l'un desdits trois points, ne sont pas parallèles. De préférence, ces trois points peuvent se situer tous deux sur une zone plane de la surface du motif. On est en particulier dans ce cas si le motif est une pyramide régulière dont la base (comprise dans le plan général de la face texturée de la plaque) est un triangle équilatéral.

Les motifs rejoignent le plan général de la face texturée de la plaque par une base, ladite base pouvant s'inscrire à l'intérieur d'un cercle dont le diamètre est généralement inférieur à 10 mm, voire inférieur à 7 mm. De préférence, le plus petit cercle pouvant contenir la base de l'un desdits motifs présente un diamètre d'au maximum 5 mm, notamment allant de 0,001 mm à 5 mm, par exemple allant de 1 à 5 mm.

Le plan général de la face texturée de la plaque est le plan contenant les points de la face texturée n'appartenant pas aux motifs (situés entre les motifs) ou les points de la face texturée en marge des motifs (notamment les points de jonction de motifs jointifs).

Généralement, le point du motif le plus éloigné du plan général de la face texturée de la plaque est distant dudit plan d'une distance allant de 0,1 D à 2 D, D représentant le diamètre du plus petit cercle contenu dans le plan général de la face texturée de la plaque et pouvant contenir la base dudit motif.

Les motifs peuvent par exemple avoir la forme de cône ou de pyramide à base polygonale comme triangulaire ou carrée ou rectangulaire ou hexagonale ou octogonale, lesdits motifs pouvant être convexes, c'est-à-dire venant en excroissance par rapport au plan général de la face texturée de la plaque, ou être concaves, c'est-à-dire venant en creux dans la masse de la plaque.

Pour le cas où les motifs ont la forme de cône ou de pyramide , on préfère que tout demi-angle au sommet dudit cône ou de ladite pyramide soit inférieur à 70°, et de préférence soit inférieur à 60°, par exemple aille de 25 à 50°. Une valeur particulièrement adaptée est 45°, notamment lorsque la surface texturée est en contact avec l'air, car cette valeur combine bien les deux propriétés « antireflet » et « piégeage de la lumière ».

Dans le cas d'un cône, le demi-angle au sommet, non nul, est l'angle entre d'une part la droite perpendiculaire à la plaque passant par le sommet du cône et d'autre part la surface conique du cône. Dans le cas d'une pyramide, un demi-angle au sommet, non nul, est l'angle entre d'une part la droite perpendiculaire à la plaque passant par le sommet de la pyramide et d'autre part la bissectrice de l'angle au sommet de l'une des faces de ladite pyramide. Le demi-angle au sommet alpha est représenté sur la figure 2 pour un motif en forme de cône et de pyramide à base triangulaire ou carrée. Ces valeurs d'angle sont valables que le cône ou la pyramide soit concave ou convexe. Si la pyramide a comme base un polygone régulier (polygone dont tous les côtés sont de même longueur), il n'y a qu'une seule valeur de demi-angle au sommet. Si la pyramide a comme base un polygone irrégulier comme un rectangle, il y a plusieurs demi-angles au sommet, et dans ce cas, on cherche à ce que tous les demi-angles au sommet aient les valeurs précédemment données.

De préférence, les motifs sont le plus proche possible les uns des autres, et ont par exemple leurs bases distantes de moins de 1 mm, et de préférence de moins de 0,5 mm.

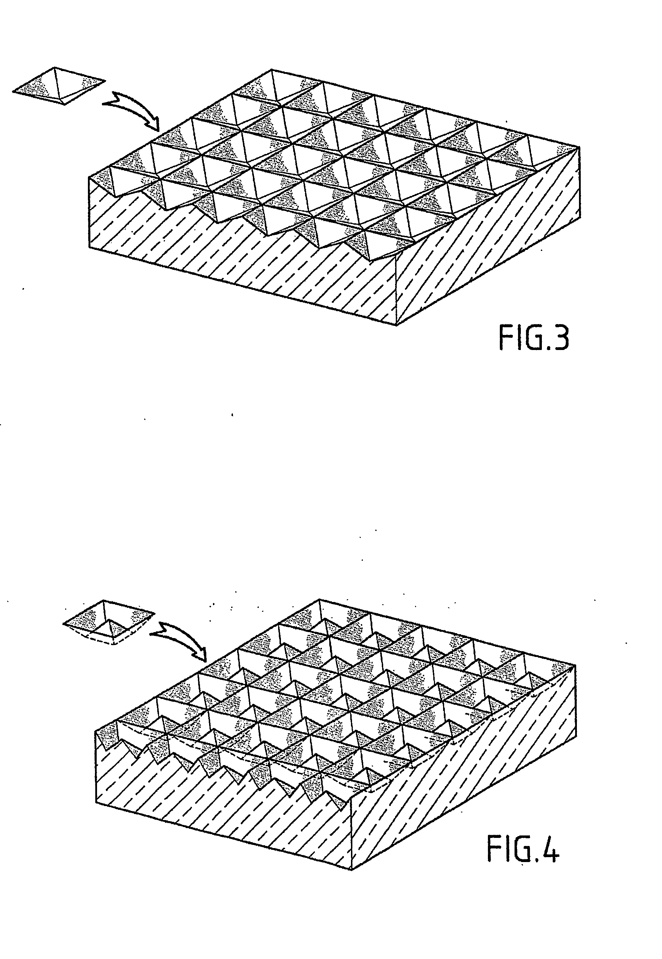

De manière encore préférée, les motifs sont jointifs. Des motifs sont dit jointifs lorsqu'ils se touchent en au moins une partie de leur surface. Des cônes peuvent être jointifs si les cercles qui constitue leur base se touchent. On préfère que les motifs soient jointifs car ainsi la surface de la plaque est plus texturée et la transmission lumineuse est encore améliorée. Certains motifs ne permettent pas une jonction totale entre les motifs. C'est notamment le cas lorsque le motif est un cône, puisque même si les cercles des bases des cônes se touchent, il reste une certaine surface entre les cercles n'appartenant pas aux motifs. Par jonction totale, on entend le fait que le contour de la base d'un motif fait également entièrement partie des contours de ses motifs voisins. Certains motifs peuvent être totalement jointifs, de sorte que l'intégralité de la surface de la plaque fasse partie d'au moins un motif. En particulier, des pyramides à base carrée ou rectangulaire ou hexagonale peuvent être totalement jointives si elles sont identiques. Dans le cas de bases carrées (voir figure 3) ou rectangulaires, il convient également que lesdites bases soient alignées pour que les motifs soient totalement jointifs. Dans le cas de bases hexagonales, il convient que lesdites bases forment un nid d'abeille.

La figure 3 représente une plaque texturée présentant à sa surface un ensemble de motifs concaves alignés et totalement jointifs, lesdits motifs ayant la forme de pyramides à base carrée.

Les motifs peuvent être en partie concaves et en partie convexe, comme un exemple est donné sur la figure 4.

De préférence, l'essentiel de la masse (c'est-à-dire pour au moins 98 % en masse), voire la totalité de la plaque est constituée de matériau(x) présentant la meilleure transparence possible et ayant de préférence une absorption linéique inférieure à 0,01 mm⁻¹ dans la partie du spectre utile à l'application, généralement le spectre allant de 380 à 1200 nm. On est notamment dans ce cas lorsque la plaque est constituée d'un tel matériau, le cas échéant munis d'une ou plusieurs couches minces du type diffusante ou barrière à certaines longueurs d'onde ou anti-salissure ou conductrice et décrites plus en détail par la suite. De préférence, cette absorption linéique est d'autant plus faible que l'épaisseur de matériau est élevée pour conserver une transmission lumineuse la plus importante possible.

Dans le cas de l'utilisation d'un verre pour entrer dans la composition de la plaque, on utilise de préférence un verre extra-clair, c'est-à-dire un verre présentant une absorption linéique inférieure à 0,008 mm⁻¹ dans le spectre des longueurs d'ondes allant de 380 à 1200 nm. Ainsi, si la plaque comprend un verre, celui-ci présente de préférence une absorption linéique inférieure à 0,008 mm⁻¹ dans le spectre des longueurs d'ondes allant de 380 à 1200 nm. La masse de la plaque peut être essentiellement (c'est-à-dire pour au moins 98 % en masse), voir entièrement, constituée d'un tel verre. On est notamment dans ce cas lorsque la plaque est constituée d'un tel verre, le cas échéant munis d'une ou plusieurs couches minces du type diffusante ou barrière à certaines longueurs d'onde ou anti-salissure ou conductrice et décrites plus en détail par la suite.

La plaque selon l'invention peut avoir une épaisseur totale allant de 0,5 à 10 mm. Lorsqu'on l'utilise comme plaque protectrice d'une cellule photo-électrique, la plaque a de préférence une épaisseur totale allant de 2 à 6 mm.

La plaque selon l'invention peut être munie d'un revêtement antireflet placé du côté de la surface texturée et/ou du côté de la surface non texturée. Un tel revêtement antireflet peut par exemple être tel que décrit dans la demande PCT/FR01/01735 et obtenue de façon connue de l'homme du métier par exemple par dépôt par pulvérisation cathodique, de préférence assistée par champ magnétique, sur le verre. On préfère faire le dépôt du revêtement après avoir donné sa texturation à la plaque.

La plaque texturée selon l'invention trouve de nombreuses applications, notamment en combinaison avec un élément capable de collecter la lumière. Au moins une face texturée de la plaque selon l'invention est placée du côté de la source de lumière. Ainsi, dans l'ensemble selon l'invention, la distance entre la plaque transparente texturée et l'élément capable de collecter de la lumière, peut également être suivant le cas, inférieure à 15 cm, voire inférieure à 3 cm, voire allant de 0 à 10 mm, voire allant de 0 à 5 mm.

Les cellules photo-électriques, lorsqu'elles ne sont par recouvertes par une plaque transparente sont soumises aux diverses aggressions de leur environnement (poussières, atmosphère corrosive, intempéries, etc). La plaque selon l'invention peut être posée ou fixée directement sur la surface (généralement en silicium monocristallin ou polycristallin ou en silicium recouvert d'une couche anti-reflet comme en nitrure de silicium) d'une telle cellule de façon d'une part à la protéger des aggressions extérieures, et d'autre part de façon à transmettre à la surface collectrice de lumière une quantité plus forte de lumière. Notamment, la plaque selon l'invention peut être posée sur une cellule photoélectrique comprenant un substrat en silicium polycristallin. La surface collectrice de lumière de la cellule peut également être texturée, par exemple par des pyramide concaves, c'est-à-dire en creux dans la surface du silicium, notamment lorsqu'il s'agit de silicium monocristallin. La plaque selon l'invention peut également être fixée sur la cellule par l'intermédiaire d'une couche d'un copolymère de l'éthylène et de l'acétate de vinyle (EVA) ou d'un polyvinylbutyral (PVB) ou d'un polyuréthane (PU) ou de tout polymère adapté. La présence de ce polymère permet de fixer la plaque sur la cellule et de plus évite la présence d'air entre la plaque et la cellule. La cellule peut avoir à sa surface une couche anti-reflet, généralement en nitrure de silicium.

La plaque selon l'invention peut également être placée sur le trajet de la lumière d'un collecteur solaire. Un collecteur solaire a pour fonction de collecter la lumière dans un but de chauffage. Dans ce cas, l'élément collectant la lumière (généralement de couleur noire) et la transformant en chaleur est placé derrière la plaque selon l'invention par rapport au trajet de la lumière. La distance entre la plaque et la surface collectrice de lumière peut généralement être inférieure à 15 cm, et de préférence inférieure à 3 cm.

Suivant l'application visée, il est possible d'appliquer sur la face de la plaque la mieux appropriée au moins une couche conférant à celle-ci une propriété particulière. Notamment, on peut appliquer une couche faisant barrière à certaines longueurs d'ondes, par exemple dans les ultra-violets. On peut également appliquer sur la plaque, de préférence au moins du coté directement dans l'air ambiant, une couche anti-salissure comme une couche de TiO₂, notamment une couche faisant l'objet de la demande de brevet EP 1087916, ou une couche anti-salissure en SiO₂ ou oxycarbure de Si ou oxynitrure de Si ou oxycarbonitrure de Si comme décrit dans WO 01/32578.

La texturation est réalisée par laminage (« cast » en anglais). Dans le cas de la texturation d'une surface en verre, le procédé de laminage est particulièrement adapté. Pour ce procédé, on applique la texturation sur la surface plane d'un verre chauffé à une température à laquelle il est possible de déformer sa surface, à l'aide d'un objet solide comme un rouleau métallique ayant à sa surface la forme inverse de la texturation à former.

Suivant la forme de la texturation visée, ce procédé peut ne pas forcément mener à des formes géométriques parfaites. Notamment, dans le cas de pyramides, le sommet et les arêtes de la pyramide peuvent être arrondis.

A la texturation apportée par les motifs d'un coté de la plaque, on peut également ajouter, de l'autre côté de la plaque, une texturation apportée par une couche rugueuse. Une telle plaque munie d'une couche rugueuse est particulièrement adaptée à la protection d'une cellule photoélectrique, du fait que ladite plaque transmet particulièrement bien la lumière. Dans cette application, la couche rugueuse est placée du côté de la cellule photoélectrique (synonyme de cellule solaire). Cette couche rugueuse peut par exemple être une couche transparente conductrice à base d'oxyde(s) métallique(s), ladite couche présentant une rugosité RMS d'au moins 3nm, notamment d'au moins 5nm et/ou une taille moyenne des motifs de cette rugosité d'au moins 50nm. Ce type de couche conductrice est connue sous l'abréviation anglaise T.C.O pour «Transparent Conductive Oxide». Elle est largement utilisée dans le domaine des cellules solaires et de l'électronique.

La rugosité R.M.S signifie rugosité « Root Mean Square ». Il s'agit d'une mesure consistant à mesurer la valeur de l'écart quadratique moyen de la rugosité. Cette rugosité R.M.S, concrètement, quantifie donc la hauteur moyenne des pics de rugosité, par rapport à une hauteur moyenne.

La couche conductrice a une nature chimique connue, elle est de type oxyde métallique dopé. Par contre, elle a la spécificité d'être hautement rugueuse. De préférence, cette rugosité est aléatoire, en ce sens qu'elle ne présente pas de motifs d'une géométrie précise. En outre, elle est dispersée, suivant la taille de la surface mesurée. Cette rugosité particulière permet, aux interfaces entre la couche et les matériaux qui l'encadrent, une diffusion accrue de la lumière incidente, qui « oblige » celle-ci à avoir une trajectoire beaucoup plus longue à travers la cellule solaire. La couche conductrice peut être déposée par pulvérisation cathodique ou par pyrolyse , notamment en phase gazeuse. Elle peut être choisie parmi l'oxyde d'étain dopé, notamment au fluor ou à l'antimoine, l'oxyde de zinc dopé, notamment à l'aluminium, et l'oxyde d'indium dopé, notamment à l'étain. Une telle couche est particulièrement adaptée lorsqu'elle est déposée sur un substrat verrier, ce qui signifie dans ce cas que la face de la plaque opposée à la face présentant la texturation selon l'invention, est celle d'un substrat verrier. Entre le substrat verrier et la couche conductrice, on peut disposer au moins une couche à fonction de barrière aux espèces susceptibles de diffuser en provenance du verre, notamment les alcalins, la couche barrière pouvant être à base d'oxyde, d'oxycarbure, d'oxynitrure ou de nitrure de silicium, notamment déposée par pyrolyse ou par pulvérisation cathodique. La couche conductrice a généralement une résistance par carré d'au plus 30 ou 20 Ω/□, notamment d'au plus 15 Ω/□. La couche conductrice a généralement une épaisseur d'au plus 700nm, notamment d'au plus 650nm, et de préférence comprise entre 400 et 600nm. La face du substrat verrier sur laquelle est disposée directement ou non la couche conductrice peut présenter une rugosité R.M.S d'au moins 1000nm, notamment comprise entre 1000 et 5000nm, et/ou une rugosité telle que la taille moyenne des motifs est d'au moins 5µm, notamment comprise entre 5 et 100µm. La rugosité de la face du substrat verrier sur laquelle est disposée directement ou non la couche conductrice peut être non uniforme/aléatoire. La face du substrat verrier sur laquelle est disposée directement ou non la couche conductrice peut présenter une rugosité provoquant une diffusion de la lumière transmise vers l'avant, le substrat présentant notamment une transmission lumineuse globale d'au moins 70 à 75%, dont une transmission lumineuse diffuse d'au moins 40 à 45%.

### Exemples :

Une plaque selon l'invention peut être réalisée à partir d'un verre plat extra-clair de marque Diamant commercialisé par Saint-Gobain Glass, d'absorption linéique inférieure à 8.10⁻³ mm⁻¹ sur le spectre des longueurs d'onde allant de 380 à 1200 nm et d'épaisseur 4 mm, en réalisant sur cette plaque et par laminage à sa température de déformation, une texturation concave composée d'un assemblage de pyramides à base carré jointives de dimension : 0,5 mm de côté pour la base et de demi-angle au sommet de 45°, l'épaisseur totale de la plaque restant de 4 mm après texturation. Cette plaque peut être fixée par l'intermédiaire d'une résine à la surface en silicium polycristallin d'une cellule photo-électrique, ladite surface étant revêtue d'une couche de nitrure de silicium de 75 nm d'épaisseur. En illuminant la surface texturée dans les conditions de la norme ASTM 892/87 utilisant le spectre AM 1.5 et en faisant varier l'angle d'incidence, on peut mesurer le pourcentage de transmission lumineuse. Le tableau ci-dessous rassemble les résultats obtenus par calcul, notamment en comparaison avec une plaque de même nature et non-texturée (les deux faces sont planes), et d'épaisseur totale égale à celle de la plaque texturée. Un angle d'incidence de 0° correspond à une direction de la lumière perpendiculaire au plan général de la face texturée de la plaque.

| | **Angle d'incidence (°)** | | | | | | | | |
|---|---|---|---|---|---|---|---|---|---|
| **Motif** | 0 | 10 | 20 | 30 | 40 | 50 | 60 | 70 | 80 |
| **Absence de texturation (surface plane)** | 85,1 | 85,1 | 85 | 84,9 | 84,5 | 83,3 | 80,6 | 73,6 | 55,15 |
| **Présence de pyramides** | 90,0 | 91,0 | 91,9 | 89 | 88,5 | 88,2 | 86,2 | 84,1 | 77,0 |

## Revendications

1. Plaque en verre laminé dont l'absorption linéique est inférieure à 0,008mm⁻¹ dans le spectre allant de 380 à 1200 nm, ladite plaque étant texturée au cours du laminage sur au moins une de ses faces par une pluralité de motifs géométriques en relief par rapport au plan général de ladite face, la surface desdits motifs comprenant chacun au moins deux points tels qu'il existe deux plans sécants entre eux contenant chacun l'un desdits deux points et réunissant les deux conditions suivantes :
- ces plans sont tous deux perpendiculaires au plan général de la face texturée de la plaque, et
- ces plans contiennent chacun l'une des deux droites perpendiculaires à ladite surface et passant par l'un desdits deux points.

2. Plaque selon la revendication précédente **caractérisée en ce que** les motifs sont des pyramides ayant ses demi-angles au sommet non nul.

3. Plaque selon la revendication précédente **caractérisée en ce que** la base des pyramides est polygonale.

4. Plaque selon la revendication 1 **caractérisée en ce que** les motifs sont des cônes ayant un demi-angle au sommet non nul.

5. Plaque selon l'une des revendications de plaque précédentes **caractérisée en ce que** tout demi-angle au sommet est inférieur à 70°.

6. Plaque selon la revendication précédente **caractérisée en ce que** tout demi-angle au sommet est inférieur à 60°.

7. Plaque selon la revendication précédente **caractérisée en ce que** tout demi-angle au sommet va de 25 à 50°.

8. Plaque selon l'une des revendications de plaque précédentes **caractérisée en ce que** le plus petit cercle pouvant contenir la base des motifs s'inscrit dans un cercle de diamètre d'au maximum 5 mm.

9. Plaque selon la revendication précédente **caractérisée en ce que** le plus petit cercle pouvant contenir la base des motifs s'inscrit dans un cercle de diamètre allant de 1 mm à 5 mm.

10. Plaque selon l'une des revendications de plaque précédentes **caractérisée en ce que** le point du motif le plus éloigné du plan général de la face texturée de la plaque est distant dudit plan d'une distance allant de 0,1 D à 2 D, D représentant le diamètre du plus petit cercle contenu dans le plan général de la face texturée de la plaque et pouvant contenir la base dudit motif.

11. Plaque selon l'une des revendications de plaque précédentes **caractérisée en ce qu'**elle comprend des motifs jointifs.

12. Plaque selon l'une des revendications 1 à 2 **caractérisée en ce qu'**elle comprend des motifs totalement jointifs.

13. Utilisation d'une plaque de l'une des revendications de plaque précédentes pour augmenter la collecte de lumière par une cellule photoélectrique.

14. Utilisation selon la revendication précédente, **caractérisée en ce que** la cellule comprend un substrat en silicium polycristallin.

15. Ensemble comprenant une plaque transparente texturée en verre laminé selon une des revendications 1 à 12 et un élément capable de collecter de la lumière, la distance entre ladite plaque et ledit élément étant inférieure à 15 cm, la face texturée augmentant la transmission de la lumière par la plaque et étant placée du côté de la réception de la lumière.

16. Ensemble selon la revendication 15, **caractérisé en ce que** la distance entre la plaque et l'élément est inférieure à 3 cm.

17. Ensemble selon la revendication précédente **caractérisé en ce que** la distance entre la plaque et l'élément va de 0 à 10 mm.

18. Ensemble selon la revendication précédente **caractérisé en ce que** la distance entre la plaque et l'élément va de 0 à 5 mm.

19. Ensemble selon l'une des revendications 15 à 18 **caractérisé en ce que** l'élément est une cellule photoélectrique.

20. Ensemble selon la revendication précédente **caractérisé en ce que** la cellule photoélectrique comprend un substrat en silicium polycristallin.

21. Ensemble selon l'une des revendications 15 à 16 **caractérisé en ce qu'**il est un collecteur solaire.

## Claims

1. Laminated glass panel whose linear absorption is less than 0.008 mm⁻¹ within the spectrum ranging from lamination on at least one of its faces by a plurality of geometrical features in relief relative to the general plane of said face, the surface of said features each having at least two points such that there exists two mutually intersecting planes each containing one of said two points and fulfilling the following two conditions:
- these planes are both perpendicular to the general plane of the textured face of the panel; and
- these planes each contain one of the two straight lines perpendicular to said surface and passing through one of said two points.

2. Panel according to the preceding claim, **characterized in that** the features are pyramids having its apex half-angles non-zero.

3. Panel according to the preceding claim, **characterized in that** the base of the pyramids is polygonal.

4. Panel according to Claim 1, **characterized in that** the features are cones having a non-zero apex half-angle.

5. Panel according to one of the preceding panel claims, **characterized in that** any apex half-angle is less than 70°.

6. Panel according to the preceding claim, **characterized in that** any apex half-angle is less than 60°.

7. Panel according to the preceding claim, **characterized in that** any apex half-angle ranges from 25 to 50°.

8. Panel according to one of the preceding panel claims, **characterized in that** the smallest circle that may contain the base of the features is inscribed in a circle having a diameter of at most 5 mm.

9. Panel according to the preceding claim, **characterized in that** the smallest circle that may contain the base of the features is inscribed in a circle having a diameter ranging from 1 to 5 mm.

10. Panel according to one of the preceding panel claims, **characterized in that** the point on the feature furthest away from the general plane of the textured face of the panel is separated from said plane by a distance ranging from 0.1D to 2D, D representing the diameter of the smallest circle contained in the general plane of the textured face of the panel and able to contain the base of said feature.

11. Panel according to one of the preceding panel claims, **characterized in that** it has touching features.

12. Panel according to either of Claims 1 and 2, **characterized in that** it has completely touching features.

13. Use of a panel of one of the -preceding panel claims to increase the collection of light by a photoelectric cell.

14. Use according to the preceding claim, **characterized in that** the cell has a polycrystalline silicon substrate.

15. Assembly comprising a textured transparent panel of laminated glass according to one of Claims 1 to 12, and an element capable of collecting light, the distance between said panel and said element being less than 15 cm, the textured face increasing the light transmission through the panel and being placed on the side on which the light is received.

16. Assembly according to Claim 15, **characterized in that** the distance between the panel and the element is less than 3 cm.

17. Assembly according to the preceding claim, **characterized in that** the distance between the panel and the element ranges from 0 to 10 mm.

18. Assembly according to the preceding claim, **characterized in that** the distance between the panel and the element ranges from 0 to 5 mm.

19. Assembly according to one of Claims 15 to 18, **characterized in that** the element is a photoelectric cell.

20. Assembly according to the preceding claim, **characterized in that** the photoelectric cell has a polycrystalline silicon substrate.

21. Assembly according to one of Claims 15 to 16, **characterized in that** it is a solar collector.

## Patentansprüche

1. Platte aus einem Walzglas, dessen lineare Absorption weniger als 0,008 mm⁻¹ in einem Spektrum von 380 bis 1 200 nm beträgt, welche auf wenigstens einer Seite mit einer Vielzahl geometrischer Muster, die in Bezug auf die allgemeine Ebene dieser Seite räumlich sind, während des Walzens texturiert worden ist, wobei die Oberfläche dieser Muster jeweils derart mindestens zwei Punkte umfasst, dass zwei einander schneidende Ebenen vorhanden sind, die jeweils einen der zwei Punkte enthalten und die zwei folgenden Bedingungen in sich vereinigen:
- diese Ebenen verlaufen beide senkrecht zur allgemeinen Ebene der texturierten Seite der Platte und
- diese Ebenen enthalten jeweils eine der zwei Geraden, die senkrecht zu dieser Oberfläche stehen und durch einen dieser zwei Punkte gehen.

2. Platte nach dem vorhergehenden Anspruch, **dadurch gekennzeichnet, dass** die Muster Pyramiden mit einem halben Pyramidenwinkel, der ungleich Null ist, sind.

3. Platte nach dem vorhergehenden Anspruch, **dadurch gekennzeichnet, dass** die Grundfläche der Pyramiden polygonal ist.

4. Platte nach Anspruch 1, **dadurch gekennzeichnet, dass** die Muster Kegel mit einem halben Kegelwinkel, der ungleich Null ist, sind.

5. Platte nach einem der sie betreffenden vorhergehenden Ansprüche, **dadurch gekennzeichnet, dass** jeder halbe Winkel an der Spitze kleiner als 70° ist.

6. Platte nach dem vorhergehenden Anspruch, **dadurch gekennzeichnet, dass** jeder halbe Winkel an der Spitze kleiner als 60° ist.

7. Platte nach dem vorhergehenden Anspruch, **dadurch gekennzeichnet, dass** jeder halbe Winkel an der Spitze 25 bis 50° beträgt.

8. Platte nach einem der sie betreffenden vorhergehenden Ansprüche, **dadurch gekennzeichnet, dass** der kleinste Kreis, der die Grundfläche der Muster enthalten kann, in einen Kreis mit einem Durchmesser von höchstens 5 mm einbeschrieben ist.

9. Platte nach dem vorhergehenden Anspruch, **dadurch gekennzeichnet, dass** der kleinste Kreis, der die Grundfläche der Muster enthalten kann, in einen Kreis mit einem Durchmesser von 1 bis 5 mm einbeschrieben ist.

10. Platte nach einem der sie betreffenden vorhergehenden Ansprüche, **dadurch gekennzeichnet, dass** der Punkt des Musters, der am weitesten von der allgemeinen Ebene der texturierten Seite der Platte entfernt ist, von dieser Ebene mit einem Abstand von 0,1 D bis 2D entfernt ist, wobei D den Durchmesser des kleinsten Kreises bedeutet, der in der allgemeinen Ebene der texturierten Seite der Platte enthalten ist und die Grundfläche des Musters enthalten kann.

11. Platte nach einem der sie betreffenden vorhergehenden Ansprüche, **dadurch gekennzeichnet, dass** sie miteinander verbundene Muster umfasst.

12. Platte nach Anspruch 1 oder 2, **dadurch gekennzeichnet, dass** sie vollständig miteinander verbundene Muster umfasst.

13. Verwendung einer Platte nach einem der sie betreffenden vorhergehenden Ansprüche zur Erhöhung der Lichtsammlung einer photoelektrischen Zelle.

14. Verwendung nach dem vorhergehenden Anspruch, **dadurch gekennzeichnet, dass** die Zelle ein Substrat aus polykristallinem Silicium umfasst.

15. Einheit, die eine texturierte transparente Platte aus Walzglas nach einem der Ansprüche 1 bis 12 und ein Element, das in der Lage ist, das Licht zu sammeln, umfasst, wobei der Abstand zwischen dieser Platte und diesem Element weniger als 15 cm beträgt und die texturierte Seite den Lichttransmissionsgrad der Platte erhöht und auf der Seite der Lichteinstrahlung angeordnet ist.

16. Einheit nach Anspruch 15, **dadurch gekennzeichnet, dass** der Abstand zwischen der Platte und dem Element weniger als 3 cm beträgt.

17. Einheit nach dem vorhergehenden Anspruch, **dadurch gekennzeichnet, dass** der Abstand zwischen der Platte und dem Element 0 bis 10 mm beträgt.

18. Einheit nach dem vorhergehenden Anspruch, **dadurch gekennzeichnet, dass** der Abstand zwischen der Platte und dem Element 0 bis 5 mm beträgt.

19. Einheit nach einem der Ansprüche 15 bis 18, **dadurch gekennzeichnet, dass** das Element eine photoelektrische Zelle ist.

20. Einheit nach dem vorhergehenden Anspruch, **dadurch gekennzeichnet, dass** die photoelektrische Zelle ein Substrat aus polykristallinem Silicium umfasst.

21. Einheit nach Anspruch 15 oder 16, **dadurch gekennzeichnet, dass** sie ein Sonnenkollektor ist.
